# FASCICULE DE BREVET EUROPEEN

(11) **EP 0 534 820 B1**
(45) Date de publication et mention de la délivrance du brevet: **03.04.1996**
(21) Numéro de dépôt: 92402515.8
(22) Date de dépôt: 15.09.1992
(51) Int. Cl.: H01S 3/14, H01S 3/094, H01S 3/0941, H01S 3/23, H01S 3/06, H04B 10/00

(54) **Source monofréquence de moyenne puissance à fibre optique**
Faseroptische monofrequente Laserquelle mittlerer Leistung
Fiber optic single frequency medium power source

(30) Priorité: 24.09.1991 FR 9111742
(43) Date de publication de la demande: 31.03.1993
(73) Titulaire: THOMSON-CSF, F-75008 Paris (FR)
(72) Inventeur: Pocholle, Jean-Paul, F-92402 Courbevoie Cédex (FR); Papuchon, Michel, F-92402 Courbevoie Cédex (FR); Puech, Claude, F-92045 Paris la Défense (FR)
(74) Mandataire: Guérin, Michel

(56) Documents cités:
- EP-A- 0 419 059
- IEEE PHOTONICS TECHNOLOGY LETTERS,vol. 2, no. 8, Août 1990, New York,US;pages 562 - 564 J.B. SCHLAGER et al.:"Subpicosecond pulse compression and Ramangeneration using a mode-locked Erbium-doped fiber laser-amplifier"
- OPTICS LETTERS, vol. 14, no. 18, 15 Septembre 1989, New York,US;pages 999 -1001 Y. KIMURA et al.:"Laser-diode-pumped mirror-free Er3+ doped fiber laser"
- IEEE PHOTONICS TECHNOLOGY LETTERS,vol. 2, no. 3, Mars 1990, New York,US; pages 156-158; D.L.MCDANIEL, Jr. et al.: "Vertical cavity surface-emitting semiconductor laser with cw injection laser pumping"
- Springer Series in Chemical Physics 5, W.Demtröder, "Laser Spectroscopy - Basic Concepts and Instrumentation", Second Corrected Printing (1982), p.344-345.

## Description

Le domaine de l'invention est celui des sources optiques cohérentes de moyenne puissance.

Actuellement les systèmes de télécommunications utilisent de plus en plus la transmission d'informations par fibres optiques, utilisant en outre des fibres optiques amplificatrices, afin d'augmenter la distance entre récepteurs.

Ces fibres sont généralement dopées à l'aide de terres rares permettant d'obtenir un effet laser sur les transitions radiatives de l'ion excité terre rare. Pour générer l'émission stimulée à une longueur d'onde L_{S}, il est nécessaire d'introduire une inversion de population entre état fondamental et état excité au niveau de l'ion terre rare, par une excitation extérieure appelée habituellement pompage. Cette opération de pompage est généralement réalisée par une diode laser dont l'émission est centrée sur la bande d'absorption de l'ion terre rare. Ainsi, un signal émis à la longueur d'onde L_{S} peut générer l'émission stimulée à la même longueur d'onde, entraînant une amplification du signal au sein de la fibre optique. L'ensemble émetteur de signal, fibre optique amplificatrice constitue une source de lumière cohérente très avantageuse car générant de fortes densités de puissance. Notamement ce type de source peut être utilisé comme source primaire d'un laser de puissance encore plus élevée.

C'est pourquoi la présente invention propose une construction particulièrement simple et compacte de ce type de source optique cohérente de moyenne puissance, n'utilisant qu'une seule source de pompage pour exciter la terre rare insérée dans la fibre optique et alimenter optiquement la source de signal. Ainsi, la source optique cohérente de moyenne puissance selon l'invention comprend :
- un seul laser de pompage émettant à la longueur d'onde L_{P} ;
- une source cohérente de signal émettant à une longueur d'onde L_{S} ;
- une fibre optique amplificatricee dopée avec une terre rare, cette fibre recevant la lumière de pompage et la lumière de la source de signal et émettant à la longueur d'onde L_{S} ; la source cohérente de signal et la terre rare de la fibre optique étant excitées à la même longueur d'onde Lₚ par le seul laser de pompage, et la fibre optique et la source de signal étant placées de part et d'autre du laser de pompage dans l'axe d'émission dudit laser de pompage, le laser de pompage étant transparent à la longueur d'onde de la source de signal et étant traversé par le faisceau de cette source.

Le laser de pompage émet de préférence un faisceau arrivant sur la source de signal dans une direction parallèle au faisceau émis par la source de signal. La source de signal peut recevoir le faisceau du laser de pompage dans une direction opposée à la direction du faisceau qu'elle émet. Cette source de signal présente de préférence une structure telle qu'elle n'émette qu'une seule fréquence. Il peut s'agir d'une diode laser à émission surfacique ou d'un petit barreau laser comprenant un matériau actif et deux miroirs de manière à former une cavité résonante, l'épaisseur de la cavité étant suffisamment petite pour ne générer qu'une fréquence d'émission sous l'action du pompage optique.

Puisque le milieu constituant le laser de pompage est transparent à la longueur d'onde de la source de signal, il peut être traversé par le faisceau de cette source, ce qui permet d'envisager un montage particulièrement compact dans lequel la fibre optique et la source de signal sont placées de part et d'autre du laser de pompage, dans l'axe d'émission dudit laser de pompage.

La présente invention sera mieux comprise et d'autres avantages apparaîtront à la lecture de la description qui va suivre, donnée à titre non limitatif et grâce aux figures annexées parmi lesquelles :
- la figure 1 représente un exemple de source de signal de type diode laser à émission surfacique, pouvant être utilisée dans la source de lumière cohérente de moyenne puissance selon l'invention ;
- la figure 2 illustre un exemple de source selon l'invention dans lequel le laser de pompage est transparent et traversé par l'onde signal.

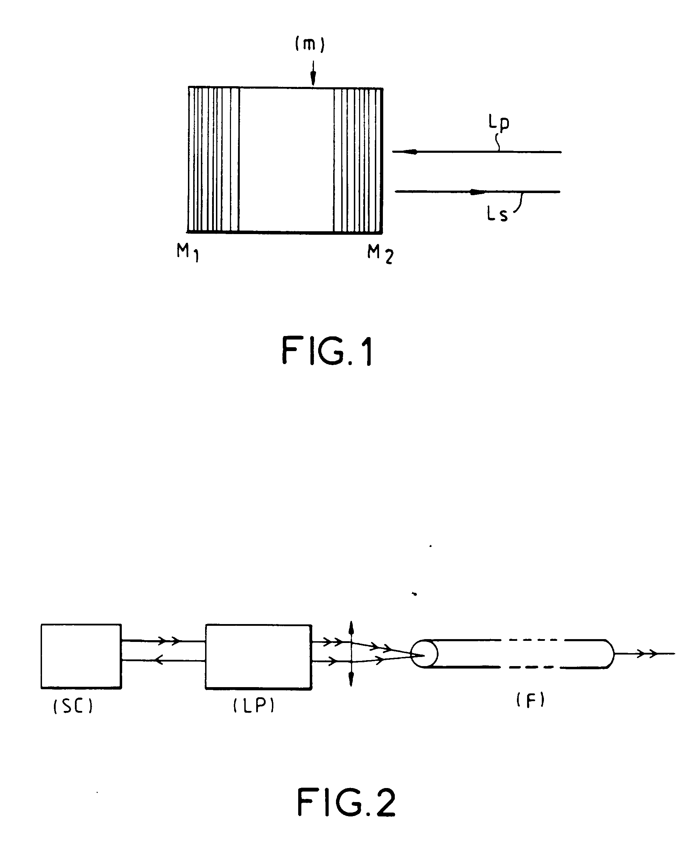

La source optique cohérente de moyenne puissance selon l'invention comprend un unique laser de pompage (L_{P}) émettant à une longueur d'onde L_{P} permettant d'alimenter optiquement à la fois une source cohérente de signal (SC) de longueur d'onde L_{S} et la fibre amplificatrice (F). De préférence le laser de pompage (LP) est une diode laser dont la nature du matériau semiconducteur dépend de la longueur d'onde de la pompe L_{P}. A titre d'exemple une diode laser obtenue par croissance de composés pseudomorphiques GaInAs/GaAlAs génère une onde de pompe à 0,98 µm alors qu'une diode laser GaInAsP génère une onde de pompe à 1,48 µm. Le laser de pompage émet un faisceau arrivant sur la source de signal (SC) dans une direction parallèle au faisceau émis par la source de signal. Cette source de signal se compose d'une partie active constituée par un matériau capable d'être le siège d'une inversion de population entre état fondamental et état excité et de générer une émission radiative cohérente, et de deux miroirs déposés de part et d'autre du matériau actif. La source de signal (SC) peut être une diode laser à émission surfacique obtenue à partir d'un empilement de couches d'un matériau actif et de structures réalisant la fonction miroir type miroirs de Bragg. La figure 1 illustre ce type de diode laser photopompée par un laser, les faisceaux optiques de pompage et d'émission de signal étant dans des directions anti-parallèles. Le matériau (m) de la couche active est choisi de manière à présenter une énergie de bande interdite située spectralement dans la courbe de gain de l'espèce terre rare insérée dans la fibre optique amplificatrice. Ainsi en utilisant des fibres dopées avec de l'erbium Eᵣ ³⁺ capable de fluorescer dans la fenêtre 1,53-1,56 µm on peut choisir un matériau (m) de diode laser à émission surfacique de type GaInAsP ; l'épaisseur de la couche active étant de préférence déterminée de façon à ne générer qu'une seule fréquence d'émission permettant ainsi de disposer d'une source optique cohérente monofréquence de moyenne puissance. Une épaisseur de l'ordre du micron satisfait cette exigence. La cavité résonante est réalisée grâce à deux miroirs M₁ et M₂ disposés de part et d'autre du matériau actif. Ces miroirs peuvent être des miroirs de type Bragg constitués d'empilement de matériaux semiconducteurs transparents sur les fenêtres d'émission et de pompage. On peut également employer un miroir de Bragg M₁ et un miroir diélectrique de sortie M₂. Il est nécessaire que le miroir de sortie M₂ présente une bonne transparence à la longueur d'onde de pompe L_{P} de façon à ce que les photos puissent photoexciter le matériau (m). On adapte la nature des matériaux semiconducteurs pour obtenir la transparence du miroir de Bragg M₂ à L_{P}.

Le miroir M₁ est déterminé de manière à réfléchir au maximum l'onde signal émise à la longueur d'onde L_{S} pour rendre la cavité résonante d'une manière unidirectionnelle ; si de plus ce miroir réfléchit bien l'onde de pompe, le matériau actif peut être photoexcité davantage par aller et retour. A titre d'exemple pour une longuer d'onde de pompe L_{P}= 0,98 µm et un signal émis à L_{S} = 1,55 µm :
- la diode laser à émission surfacique peut être constituée par un matériau actif de type GaInAsP ;
- le miroir M₁ peut être réalisé par un empilement de matériaux InP/GaAs/GaAlAs ;
- le miroir M₂ peut être réalisé par un empilement de matériaux GaInAsP/InP.

Les épaisseurs totales des miroirs étant de l'ordre du micron et étant obtenus par les techniques classiques de croissance des composés semiconducteurs.

Il est également possible d'utiliser comme source de signal (SC) une petite plaque laser composé de matériau solide tel que du verre à l'erbium dopé avec des ions Eᵣ ³⁺ ou bien du grenat d'yttrium et d'aluminium (YAG) également dopé avec des ions Eᵣ ³⁺, les miroirs M₁ et M₂ pouvant être directement les faces terminales du matériau actif. L'utilisation d'une telle source de signal (SC) dans le cadre de l'invention utilise un faisceau de pompage dans une direction parallèle au faisceau émis à L_{S} alors que généralement l'opération de pompage est effectuée perpendiculairement à l'axe de la cavité résonante.

Le signal émis à la longueur d'onde L_{S} et l'onde de pompe à L_{P} sont introduits dans une fibre amplificatrice qui en sortie fournit une source cohérente de lumière de préférence monofréquence de moyenne puissance. Pour cela on utilise une optique permettant d'optimiser le couplage entre les deux faisceaux optiques et le coeur de la fibre employée. Cette fibre peut être réalisée en silice dopée avec une terre rare dont la nature est adaptée à la longueur d'onde à laquelle on s'intéresse. Ainsi pour disposer d'une source cohérente de puissance à L_{S} = 1,55 µm on peut utiliser une fibre de silice dopée à l'erbium. En effet l'ion Eᵣ ³⁺ fluoresce sur la fenêtre 1,53-1,56 µm lorsqu'il a été pompé optiquement à une longueur d'onde de pompe L_{P} = 0,808 µm ou L_{P} = 0,98 µm ou bien encore L_{P} = 1,48 µm. On adapte alors la nature du matériau actif de la source de signal (SC) de manière à ce qu'il puisse être pompé également à la même longueur d'onde de pompe L_{P} pour émettre le signal à la longueur d'onde L_{S} qui par émission stimulée dans la fibre optique ressort amplifié. On adapte également la nature des miroirs M₁ et M₂ à la longueur d'onde L_{P} que l'on a choisie ; ainsi dans le cas d'un pompage à 1,48 µm, en utilisant une diode laser à émission surfacique à base du quaternaire GaInAsP, la transparence du miroir M₁ à 1,48 µm peut être obtenue avec des miroirs de Bragg résultant de l'empilement de matériaux GaInAsP/InP.

En utilisant un laser de pompage dont le matériau actif est transparent à la longueur d'onde L_{S}, il est posible d'élaborer une source cohérente selon l'invention, en ligne donc particulièrement simple et compacte. La figure 2 illustre cet exemple de source dans laquelle le laser de pompe excite simultanément à partir de l'émission sur ces deux faces, d'une part la source cohérente de signal (SC), d'autre part la fibre amplificatrice dopée terre rare. Une telle configuration ne nécessite aucun miroir de renvoi et rend la source particulièrement pratique à manipuler.

La source selon l'invention peut être accordée aux longueurs d'onde d'émission auxquelles on s'intéresse. En effet on peut doper les fibres avec d'autres ions terres rares tels que l'holmium ; ainsi une fibre en silice dopée avec de l'holmium et codopée avec des ions Tm³⁺ peut émettre à 2,04 µm en étant pompée à une longueur d'onde L_{P} au voisinage de 0,8 µm. Une diode laser à émission surfacique élaborée à partir de composés de type AlGaAsSb comme matériau actif peut alimenter la fibre optique dopée holmium pour disposer d'une source cohérente de moyenne puissance à 2,04 µm.

Avec les sources cohérentes monofréquences de moyenne puissance selon l'invention opérant à des longueurs d'ondes choisies on dispose donc de sources également capables de jouer le rôle de sources primaires de commande de laser de plus grande puissance.

## Revendications

1. Source de lumière cohérente de moyenne puissance comprenant :
- un seul laser de pompage (LP) émettant à une longueur d'onde L_{P} ;
- une source cohérente de signal (SC) émettant à une longueur d'onde L_{S} ;
- une fibre optique amplificatrice (F) dopée avec une terre rare, cette fibre recevant la lumière du laser de pompage et la lumière de la source de signal et émettant à la longueur d'onde L_{S} ;
la source cohérente de signal et la terre rare de la fibre optique étant pompées à la même longueur d'onde L_{P} par le seul laser de pompage, et la fibre optique et la source de signal étant placées de part et d'autre du laser de pompage dans l'axe d'émission dudit laser de pompage, le laser de pompage étant transparent à la longueur d'onde de la source de signal et étant traversé par le faisceau de cette source.

2. Source de lumière cohérente de puissance selon la revendication 1, caractérisée en ce que le laser de pompage émet un faisceau qui arrive sur la source de signal dans une direction parallèle au faisceau émis par la source du signal.

3. Source de lumière cohérente de puissance selon la revendication 2, caractérisée en ce que la source de signal reçoit le faisceau du laser de pompage dans une direction opposée à la direction du faisceau qu'elle émet.

4. Source de lumière cohérente de puissance selon l'une des revendications 1 à 3, caractérisée en ce que la source de signal est une source laser monofréquence.

5. Source de lumière cohérente de puissance selon la revendication 4, caractérisée en ce que la source de signal est une diode laser à émission surfacique.

## Patentansprüche

1. Kohärente Lichtquelle mittlerer Leistung,
- mit einem einzigen Pumplaser (LP), der bei einer Wellenlänge L_{P} emittiert,
- mit einer kohärenten Signallichtquelle (SC), die bei einer Wellenlänge L_{S} emittiert,
- mit einer als Verstärker wirkenden Lichtleitfaser (F), die mit einer seltenen Erde dotiert ist und das Licht des Pumplasers und das Licht der Signalquelle empfängt und bei der Wellenlänge L_{S} aussendet, wobei die kohärente Signallichtquelle und die seltene Erde der Lichtleitfaser bei der gleichen Wellenlänge L_{P} durch den einzigen Pumplaser gepumpt werden und die Lichtleitfaser und die Signalquelle zu beiden Seiten des Pumplasers in der Emissionsachse dieses Pumplasers angeordnet sind, wobei der Pumplaser bei der Wellenlänge der Signalquelle transparent ist und von dem Strahl dieser Quelle durchquert wird.

2. Kohärente Leistungs-Lichtquelle nach Anspruch 1, dadurch gekennzeichnet, daß der Pumplaser einen Strahl emittiert, der bei der Signalquelle in einer Richtung parallel zu dem von der Signalquelle emittierten Strahl ankommt.

3. Kohärente Leistungs-Lichtquelle nach Anspruch 2, dadurch gekennzeichnet, daß die Signalquelle den Pumplaserstrahl in einer Richtung entgegengesetzt zur Richtung des Strahls empfängt, den sie emittiert.

4. Kohärente Leistungs-Lichtquelle nach einem der Ansprüche 1 bis 3, dadurch gekennzeichnet, daß die Signalquelle Signale einer einzigen Frequenz aussendet.

5. Kohärente Leistungs-Lichtquelle nach Anspruch 4, dadurch gekennzeichnet, daß die Signalquelle eine Laserdiode mit Oberflächenemission ist.

## Claims

1. Medium power coherent light source comprising:
- a single pumping laser (LP) emitting at a wavelength L_{P};
- a coherent signal source (SC) emitting at a wavelength L_{S};
- an amplifying optical fibre (F) doped with a rare earth, this fibre receiving the light from the pumping laser and the light from the signal source and emitting at the wavelength L_{S}; the coherent signal source and the rare earth of the optical fibre being pumped at the same wavelength Lₚ by the single pumping laser, and the optical fibre and the signal source being placed on either side of the pumping laser on the axis of emission of the said pumping laser, the pumping laser being transparent at the wavelength of the signal source and being traversed by the beam from this source.

2. Power coherent light source according to Claim 1, characterized in that the pumping laser emits a beam which arrives at the signal source in a direction parallel to the beam emitted by the signal source.

3. Power coherent light source according to Claim 2, characterized in that the signal source receives the beam from the pumping laser in a direction opposite to the direction of the beam which it emits.

4. Power coherent light source according to one of Claims 1 to 3, characterized in that the signal source is a single-frequency laser source.

5. Power coherent light source according to Claim 4, characterized in that the signal source is a surface-emission laser diode.
